Europäisches Patentamt

European Patent Office

Office européen des brevets

(19)

(11) Publication number: **0 055 140**
**B1**

# (12) EUROPEAN PATENT SPECIFICATION

(45) Date of publication of patent specification: 26.02.86

(51) Int. Cl.⁴: **H 01 L 21/28, H 01 L 21/64**

(21) Application number: 81306110.8

(22) Date of filing: 23.12.81

(54) Method of manufacturing a GaAs field effect transistor.

(30) Priority: 23.12.80 JP 182350/80

(43) Date of publication of application:
30.06.82 Bulletin 82/26

(45) Publication of the grant of the patent:
26.02.86 Bulletin 86/09

(84) Designated Contracting States:
DE FR GB NL

(56) References cited:
US-A-4 202 003

APPLIED PHYSICS LETTERS, Vol. 23, No. 12, 15
December 1973, New York A.K. SINHA et al.
"Effect of Alloying Behavior on the Electrical
Characteristics of n-GaAs Schottky Diodes
Metallized with W, Au, and Pt" pages 666 to
668

(73) Proprietor: Kabushiki Kaisha Toshiba
72, Horikawa-cho Saiwai-ku
Kawasaki-shi Kanagawa-ken 210 (JP)

(72) Inventor: Toyoda, Nobuyuki
A 302, Tana-doeru 3-5, Tana-machi
Midori-ku Yokohama-shi (JP)
Inventor: Hojo, Akimichi
2995 Hino-cho
Konan-ku Yokohama-shi (JP)

(74) Representative: Freed, Arthur Woolf et al
MARKS & CLERK 57-60 Lincoln's Inn Fields
London WC2A 3LS (GB)

(56) References cited:
EXTENDED ABSTRACTS, Vol. 80-2, October
1980 Princeton H. ISHIUCHI et al. "Reliability
Study of Gate Metals for GaAs MES FETs"
pages 1221 to 1223

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

## Description

The present invention relates to a method for manufacturing the gate electrode of a GaAs field effect transistor.

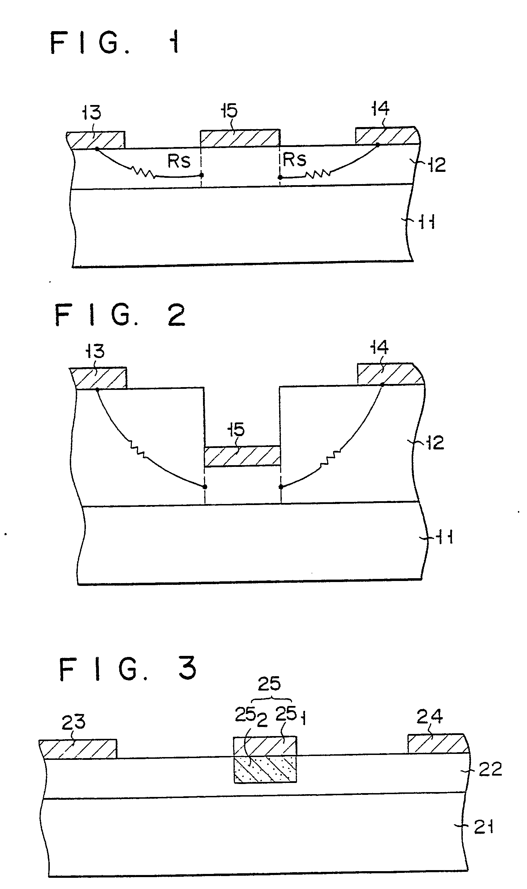

A GaAs field effect transistor with an arrangement shown in Fig. 1 is conventionally known. In the figure, reference numeral 11 denotes a GaAs semiconductor substrate; 12, an n-type active layer; 13 and 14, respectively, source and drain electrodes which are in ohmic contact with the active layer 12; and 15, a gate electrode which is in Schottky contact with the active layer 12.

The performance index of the GaAs field effect transistor (FET) is defined by gm/Cgs wherein gm is the mutual transconductance and Cgs is the capacitance between the gate and source. In an actual element as shown in Fig. 1, series resistance (Rs) is present between the gate and the source and between the gate and drain, and the actual performance index is defined by gm'/Cgs. The apparent mutual conductance gm' is defined by the following equation:

$$gm' = \frac{gm}{1 + Rs \cdot gm} \qquad (1)$$

In order to improve the high frequency performance of the GaAs FET, the transconductance gm must be increased and the capacitance Cgs between the gate and the source must be reduced. However, in fact, the series resistance Rs must often be reduced first.

Various methods for reducing the series resistance Rs have been proposed. Among them, a method for forming a so-called "recess structure" or "notch structure" is very effective in which the thick active layer 12 as shown in Fig. 2 is formed and the vinicity of the gate electrode 15 is etched to accomplish desired FET characteristics. A FET with a recess structure is known from "Extended Abstracts" Vol. 80-2, October 1980, Princeton H. Ishiuchi et al" "Reliability Study of Gate Metals for GaAs MES FET's" pages 1221 to 1223. However, with this structure, the etching precision at the gate region directly determines the controllability of the FET characteristics (such as the threshold voltage Vth and the saturation current IDSS). When the length of the gate is not more than 1 μm, the permeability of the etchant is nonuniform, resulting in variation in the FET characteristics within the wafer. The judgement of whether the etching degree is proper or improper in view of FET characteristics could not be determined until after the gate electrode has been deposited. Therefore, only experience and intuition have been relied upon as the primary criterion for the etching precision. The threshold voltage of the FET which is used in an integrated circuit comprising a GaAs semiconductor substrate is as small as −0.2 to +1.0 V. In this way, since the threshold voltage is very low, strict uniformity between the FET's in the range of 2 to 3% is required. It is very difficult to control the threshold voltage within this range by etching.

Platinum (Pt) is deposited on a GaAs crystal, and annealing is performed so that a compound whose main component is PtAs$_2$ is produced and used for effectively producing a Schottky junction ("Effect of Alloying Behaviour on the Electrical Characteristics of n-GaAs Schottky Diodes Metallized with W. Au and Pt", Applied Physics Letters, Vol. 23, No. 12 (1973), A. K. Sinha and J. M. Poate). Further, it is well known that the junction surface moves inside the GaAs crystal as the chemical reaction progresses ("Reaction Rates for Pt on GaAs", Applied Physics Letters, Vol. 24, No. 8 (1974), W. R. Wisseman and D. W. Shaw). However, there has been no example which applies this phenomenon to a semiconductor device.

It is an object of the present invention to utilize the physical phenomenon as described above and to provide an FET structure which is equivalent to a recess structure as shown in Fig. 2 in which a metal film is deposited on the surface of an active layer which is formed on a GaAs semiconductor substrate so that the metal film is in Schottky contact with the active layer; annealing is performed to produce a compound of the metal film and GaAs and to form a Schottky gate electrode; and the junction surface moves into the GaAs semiconductor substrate when the compound is produced.

According to the present invention, there is provided a method for manufacturing the gate electrode of a GaAs Schottky field effect transistor comprising the steps of forming a first metal layer by depositing on a surface of a GaAs active layer formed on a GaAs substrate at least one metal selected from the group consisting of platinum, titanium and palladium, and forming a compound layer within an active layer by reacting GaAs and the metal through an annealing treatment so that a threshold voltage of the GaAs field effect transistor is controlled.

A GaAs field effect transistor manufactured by a method according to the present invention has advantages over the FET of the recess structure in that (1) imprecise etching which results in variation of controllability of the FET characteristics is eliminated and (2) annealing is performed while checking the FET characteristics so that desired FET characteristics such as the threshold voltage and the saturation voltage are easily controlled.

This invention can be more fully understood from the following detailed description when taken in conjunction with the accompanying drawings, in which:

Fig. 1 is a sectional view for explaining an example of a conventional GaAs FET structure;

Fig. 2 is a sectional view for explaining an example of a GaAs FET of conventional recess structure;

Fig. 3 is a sectional view for explaining an embodiment of a GaAs FET structure according to an embodiment of the present invention;

Fig. 4 is a graph for explaining the relation between the heating time and the threshold voltage of the FET;

Fig. 5 is a block diagram for explaining the steps of the method for manufacturing the GaAs FET according to the present invention;

Fig. 6 is a graph for explaining the relation between the annealing time and the reacted layer thickness which accompanies the solid phase reaction of Pt and GaAs;

Fig. 7 is a graph for explaining the relation between the optimal amount of deposited Pt and the acceleration voltage;

Fig. 8 is a graph for explaining the relation between the threshold voltage and the manufacturing steps for various conditions such as the Si ion-implantation conditions and the range of thickness of deposited Pt in order to manufacture a normally-off type FET whose threshold voltage fluctuates little;

Fig. 9 is a sectional view of a laminate metal gate according to the present invention; and

Fig. 10 is a sectional view of the FET on which a laminate gate comprising Pt, Mo, Ti and Au is formed after annealing, according to the present invention.

An embodiment of a GaAs FET according to the present invention will be described with reference to the accompanying drawings. Fig. 3 shows the section of an FET manufactured by the method to be described below. Si is the ion-implanted in a GaAs semiconductor crystal 21 at a dose of $4.5 \times 10^{12}$ cm$^{-2}$ and at an acceleration voltage of 150 KV. Annealing is then performed at a temperature of 850°C for 15 minutes to form an active layer 22. An AuGe alloy is deposited as a source electrode 23 and a drain electrode 24. These electrodes are in ohmic contact with the active layer 22. A Pt film $25_1$ as a gate electrode 25 is formed to a thickness of 70 nm. Annealing is then performed in a temperature range of 300 to 500°C to produce a compound $25_2$ whose major component is PtAs$_2$. If the temperature is less than 300°C for the annealing, the reaction is too slow to produce the compound $25_2$. On the other hand, when the temperature is above 500°C, degradation in electric characteristics occurs.

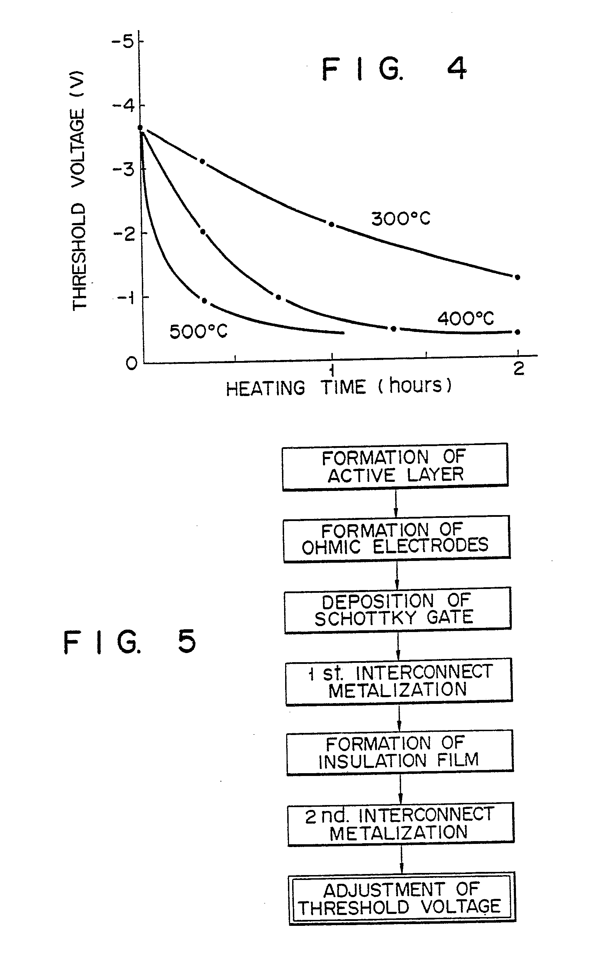

Fig. 4 shows changes in the threshold voltage Vth of the FET when the heating temperature and heating time are changed. As the heating time increases, the formation of the compound $25_2$ progresses. As shown in Fig. 3, the compound $25_2$ which underlies the gate electrode 25 penetrates into the active layer 22 and the threshold voltage decreases. In this manner, when the heating time is changed, desired FET characteristics may be achieved. The uniformity of the threshold voltage between the wafers is about ±5%. When the same wafer is used and a conventional FET of the recess structure is manufactured, the uniformity turns out to be not less than ±15%. In this way, as far as the uniformity in a wafer is concerned, the GaAs FET according to the present invention is superior to the conventional FET of the recess structure.

When unreacted gate metal remains after the threshold voltage is adjusted, this unreacted gate metal reacts with GaAs in the subsequent annealing, resulting in a change in the adjusted threshold voltage. Therefore, the adjustment of the threshold voltage must be performed after interconnect metalizations is completed, and the amount of the deposited gate metal must be minimized so that the gate metal preferably completely reacts with the GaAs.

Fig. 5 is a block diagram of one example of a process for this purpose. As shown in Fig. 5, the adjustment of the threshold voltage is performed in the final step, so that fluctuations of the threshold voltage are controlled.

For completely reacting with GaAs the metal which is deposited on the GaAs substrate, the reaction gate between the deposited metal and GaAs must be experimentally measured in advance.

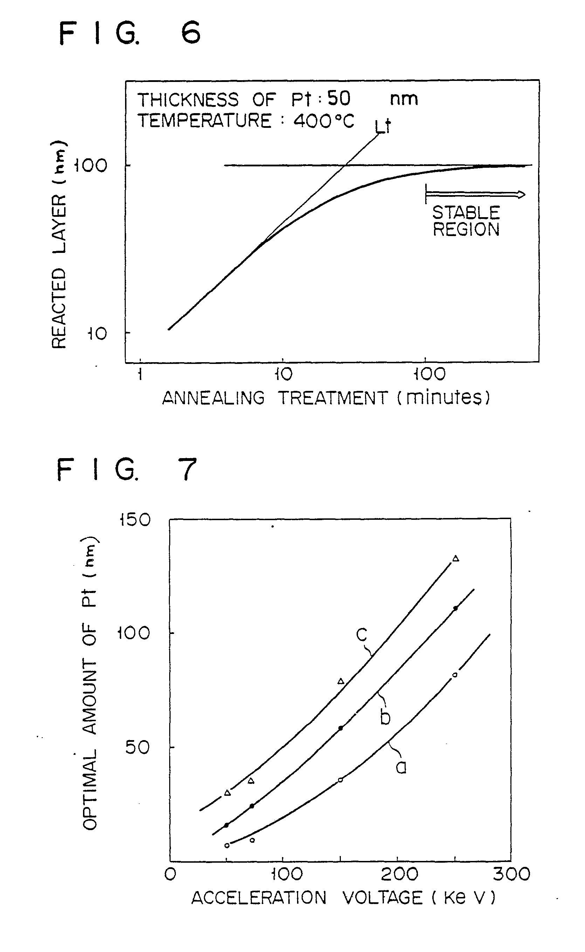

Fig. 6 shows changes in the thickness of the compound layer which is produced by the solid phase reaction between Pt and GaAs. A donor impurity is ion-implanted in the GaAs semiconductor crystal to form the active layer 22. Pt is deposited on the surface of the active layer 22 to a thickness of 50 nm. The wafer is annealed in an atmosphere of H$_2$ gas for a variable period, and the erosion rate of the active layer 22 in the solid phase reaction is measured by C-V measurement. When the annealing time is short, the erosion amount is proportional to the time. However, finally the Pt which is deposited on the active layer 22 completely reacts with the GaAs, so that no further erosion occurs. The erosion amount in this case is about 100 nm which is about twice the thickness of the deposited Pt. This state does not change when the wafer is heated at a temperature of 400°C for 100 hours. Another characteristic feature of the present invention is that the threshold voltage may be adjusted to the "stable region" as shown in Fig. 6.

Fig. 7 shows experimental data of the amount of Pt which is deposited on the active layer for forming an E · FET (enhancement type MOS FET) in which $^{28}$Si is ion-implanted in a dose range of $1 \times 10^{12}$ cm$^{-2}$ and in an acceleration voltage range of 50 to 300 KV. Curve "a" shows a case in which the dose is $1 \times 10^{12}$ cm$^{-2}$; curve "b" shows a case in which the dose is $2 \times 10^{12}$ cm$^{-2}$; and curve "c" shows a case in which the dose is $4 \times 10^{12}$ cm$^{-2}$. Based on these curves, when the amount of Pt which is deposited on the active layer 22 is varied according to the dose, the E · FET with the stable threshold voltage is accomplished. Therefore, this stable E · FET is used to manufacture a GaAs integrated circuit with high reliability.

Effects will be described with reference to an example of the present invention in which the adjustment of the threshold voltage is performed after the wiring between the elements is completed, and the amount of the gate metal which is deposited is reduced to the minimum requirement.

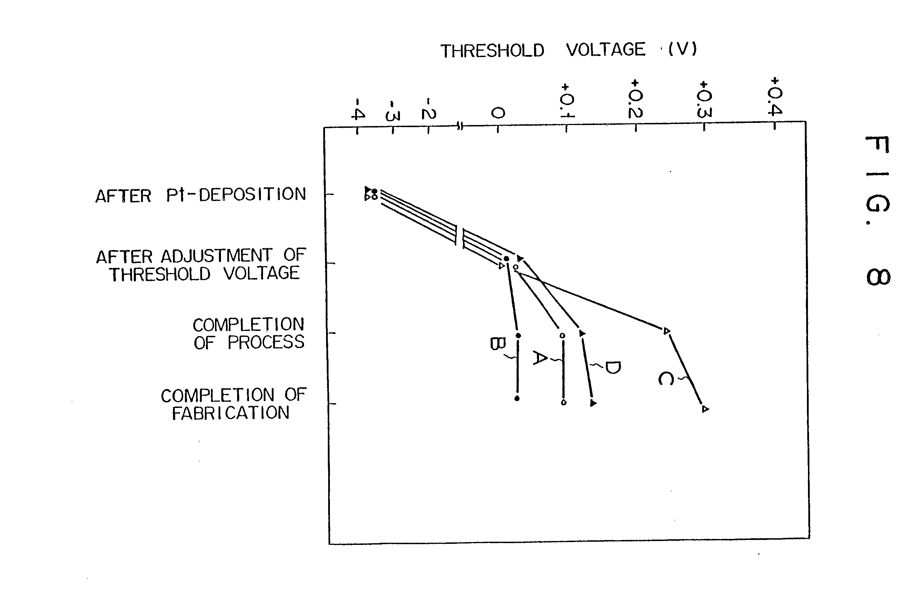

$^{28}$Si was ion-implanted in a prospective channel region of the GaAs semiconductor crystal at a dose of $4 \times 10^{12}$ cm$^{-2}$ and at an acceleration voltage of 150 KeV. The wafer was then annealed in an atmosphere of a gas mixture of AsH$_3$ and H$_2$. AuGe (Ge 5%) was deposited thereon and an alloy ohmic electrode was deposited at a temperature of 420°C for 5 minutes. This alloy ohmic electrode was divided into four samples A, B, C and D. These samples were examined. Pt was deposited on sample A to a thickness of 50 nm and the threshold voltage was adjusted after the Schottky gate electrode was deposited and before a first wiring process was performed. In this manner, the adjustment of the threshold voltage was not performed after a second interconnect metalization process was completed, as shown in Fig. 5. Pt was deposited on sample B to a thickness of 50 nm and the threshold voltage was adjusted in the same manner as shown in Fig. 5. Pt was deposited on sample C to a thickness of 1,500 Å and the threshold voltage was adjusted before the first wiring process was performed in the same manner as in sample A. Pt was deposited on sample D to a thickness of 150 nm and the threshold voltage was adjusted in the same manner as in Fig. 5. Fig. 8 shows the experimental results. As is apparent from the figure, if the same amount of Pt is deposited, the threshold voltage fluctuates little when the threshold voltage is adjusted after the second interconnect metalization process is performed. Further, it is understood that the minimum amount of Pt to be deposited must be determined to further increase the stability of the threshold voltage.

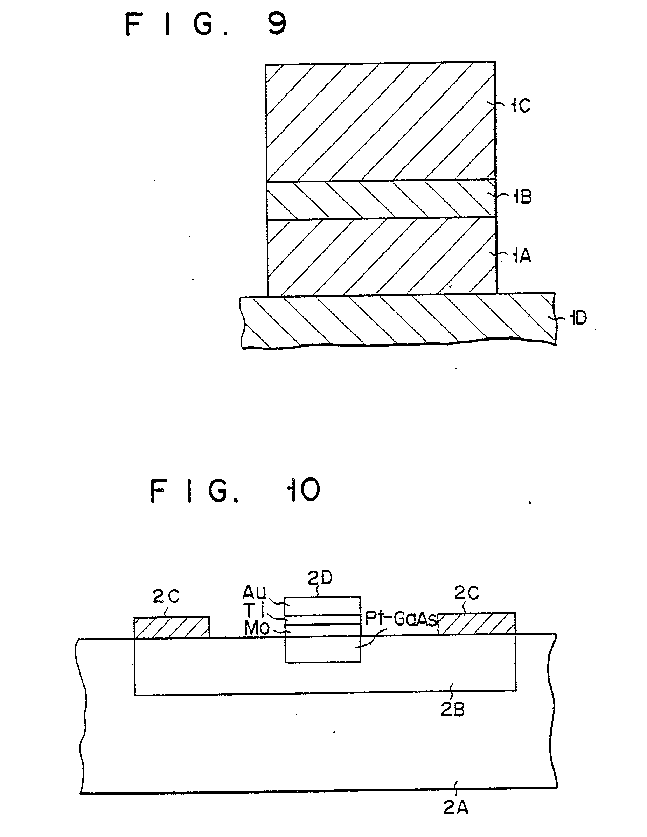

In the above example, a case is described in which metals such as Pt, Pd, and Ti which readily react with GaAs are used. However, a metal which does not react readily with GaAs may be used in combination with Pt, Pd or Ti. For example, as shown in Fig. 9, a lowermost layer 1A (first metal) may be a metal (at least one metal selected from Pt, Pd and Ti) which reacts readily with a GaAs layer 1D, a layer 1B (second metal) may be (at least one metal selected from Mo, Ta, W and Cr) which is formed on the lowermost layer 1A and which does not react readily with the GaAs layer 1D, and an uppermost layer 1C (third metal) is a metal such as Au for easy bonding if needed. These metals are sequentially formed and annealing is performed to control the threshold voltage, and the second layer (second metal) and layers which are formed thereon remain on the reacted layer, so that a gate resistance Rg is reduced. When the metal layers are not bonded well, a small amount of a suitable binder metal may be interposed therebetween.

A detailed example is described. As shown in Fig. 10, Si was selectively ion-implanted in GaAs semiconductor crystal 2A at a dose of $4 \times 10^{12}$ cm$^{-2}$ and at an acceleration voltage of 150 KeV. The wafer was then annealed in an atmosphere of a gas mixture of H$_2$ and AsH$_3$ at a temperature of 850°C for 20 minutes to form an electrically active layer 2B. AuGe (5%) was deposited on the corners of the active layer 2B and ohmic contacts 2C were formed as an alloy with the active layer 2B by the lift-off method at a temperature of 420°C for 10 minutes in an atmosphere of H$_2$. Subsequently a Pt layer of 75 nm thickness, a Mo layer of 100 nm thickness, a Ti layer of 50 nm thickness, and an Au layer of 500 nm thickness were deposited on the active layer 2B to form a gate 20 of 1 µm thickness by the lift-off method. While the current-voltage characteristics of the FET were measured, annealing was performed to control the threshold voltage. The annealing was performed at a temperature of 400°C in an atmosphere of H$_2$. After the annealing time of about 180 minutes had elapsed, the threshold voltage was about +0.03 V. On the other hand, in the same manufacturing process, an E · FET (not shown) whose gate comprised only Pt was manufactured. This E · FET was annealed for about 180 minutes and the threshold voltage thereof became about 0.01 V. The same amount of Pt was deposited on both samples. When the gate resistance Rg of the two E · FETs was measured, the gate resistance Rg for the E · FET with the four-layered gate was about 1/10 the gate resistance Rg for the F · FET with the single gate layer. On the other hand, the performance index gm of the E · FET with the four-layered gate was 4 times the performance index gm of the E · FET with the single gate.

In summary, the present invention provides an effective method for simultaneously accomplishing precise control of the threshold voltage and a decrease in the gate resistance of the normally-off type GaAs FET.

Among the metals which are used as the first metal and which easily react with GaAs, such as Pt, Pd and Ti, Pt is the most stable material for the gate electrode from the point of view of the FET characteristics.

**Claims**

1. A method for manufacturing the gate electrode of a GaAs Schottky field effect transistor comprising the steps of forming a first metal layer by depositing on a surface of a GaAs active layer formed on a GaAs substrate at least one metal selected from the group consisting of platinum, titanium and palladium, and forming a compound layer within the active layer by reacting GaAs and the metal through an annealing treatment so that the threshold voltage of the GaAs field effect transistor is controlled.

2. A method according to claim 1, characterized in that the annealing time is controlled to change the thickness of the compound layer which is produced so that the threshold voltage is controlled.

3. A method according to claim 1, characterized in that the annealing is performed after interconnect metalization between elements is completed.

4. A method according to claim 1, 2 or 3, characterized in that the metal which is deposited reacts completely with GaAs.

5. A method according to claim 4, characterized in that the amount of the metal which is deposited is the minimum amount necessary to obtain a desired threshold voltage.

6. A method according to claim 1, 2 or 4, characterized in that a second metal layer of at least one metal selected from the group consisting of Mo, Ta, W and Cr, is deposited after the first metal layer is formed, and annealing is performed to react the first metal and the GaAs so that the threshold voltage is controlled.

7. A method according to claim 6, characterized in that a third metal layer is deposited for bonding wiring layers after the second metal layer is deposited, and annealing is performed to react the first metal layer with the GaAs so that the threshold voltage is controlled.

8. A method according to claim 1, characterized in that the annealing is conducted at a temperature ranging from 300 to 500°C.

## Revendications

1. Procédé de fabrication de l'électrode de grille d'un transistor à effet de champ de Schottky en GaAs comprenant les opérations suivantes: former une première couche métallique en déposant à la surface d'une couche active en GaAs formée sur un substrat en GaAs au moins un métal choisi dans le groupe comprenant le platine, le titane et le palladium, et former une couche de composé à l'intérieur de la couche active en faisant réagir GaAs et le métal par l'intermédiaire d'un traitement de recuit de façon à ajuster la tension de seuil du transistor à effet de champ en GaAs.

2. Procédé selon la revendication 1, caractérisé en ce que l'on ajuste la durée de recuit de manière à faire varier l'épaisseur de la couche de composé qui est produite de manière à ajuster la tension de seuil.

3. Procédé selon la revendication 1, caractérisé en ce qu'on effectue le recuit après que la métallisation d'interconnexion entre éléments à été achevée.

4. Procédé selon la revendication 1, 2 ou 3, caractérisé en ce que le métal qui est déposé réagit complétement avec GaAs.

5. Procédé selon la revendication 4, caractérisé en ce que la quantité de métal que est déposée est la quantité minimale nécessaire pour obtenir une tension de seuil voulue.

6. Procédé selon la revendication 1, 2 ou 4, caractérisé en ce qu'on fait déposer une deuxième couche métallique formée d'au moins un métal choisi dans le groupe comprenant Mo, Ta, W et Cr après que la première couche métallique a été formée, et on effectue un recuit pour faire réagir le premier métal et GaAs de façon à ajuster la tension de seuil.

7. Procédé selon la revendication 6, caractérisé en ce qu'on fait déposer une troisième couche de métal pour la liaison de couches de câblage après que la deuxième couche métallique a été déposée et on effectue un recuit pour faire réagir la première couche métallique avec GaAs de façon à ajuster la tension de seuil.

8. Procédé selon la revendication 1, caractérisé en ce qu'on effectue le recuit à une température comprise entre 300 et 500°C.

## Patentansprüche

1. Verfahren zur Herstellung der Gate-Elektrode eines GaAs-Schottky-Feldeffekttransistors, umfassend die Schritte der Ausbildung eines ersten Metallschicht durch Ablagerung mindestens eines Metalls der Gruppe Platin, Titan und Palladium auf einer Oberfläche einer auf einem GaAs-Substrat erzeugten GaAs-Aktivschicht und Ausbilden einer Verbund- oder Verbindungsschicht innerhalb der Aktivschicht durch Umsetzen von GaAs und des Metalls mittels einer Glühbehandlung, so daß dadurch die Schwellenwertspannung des GaAs-Feldeffekttransistors gesteuert oder eingestellt wird.

2. Verfahren nach Anspruch 1, dadurch gekennzeichnet, daß die Glühzeit geregelt wird, um die Dicke der erzeugten Verbund- oder Verbindungsschicht so zu ändern, daß die Schwellenwertspannung eingestellt wird.

3. Verfahren nach Anspruch 1, dadurch gekennzeichnet, daß das Glühen nach Abschluß der Verbindungsmetallisierung zwischen Elementen durchgeführt wird.

4. Verfahren nach Anspruch 1, 2 oder 3, dadurch gekennzeichnet, daß sich das abgelagerte Metall vollständig mit GaAs umsetzt.

5. Verfahren nach Anspruch 4, dadurch gekennzeichnet, daß die abgelagerte Metallmenge die zur Erzielung einer gewünschten Schwellenwertspannung nötige Mindestmenge ist.

6. Verfahren nach Anspruch 1, 2 oder 4, dadurch gekennzeichnet, daß eine zweite Metallschicht aus mindestens einem Metall der Gruppe Mo, Ta, W und Cr nach der Erzeugung der ersten Metallschicht abgelagert oder aufgebracht wird und ein Glühen durchgeführt wird, um das erste Metall und das GaAs umzusetzen, so daß die Schwellenwertspannung eingestellt wird.

7. Verfahren nach Anspruch 6, dadurch gekennzeichnet, daß eine dritte Metallschicht für Anschlußleiterschichten nach dem Ablagern der zweiten Metallschicht abgelagert bzw. aufgebracht wird und ein Glühen durchgeführt wird, um die erste Metallschicht mit dem GaAs umzusetzen, so daß die Schwellenwertspannung eingestellt wird.

8. Verfahren nach Anspruch 1, dadurch gekennzeichnet, daß das Glühen bei einer Temperatur im Bereich von 300—500°C durchgeführt wird.

FIG. 1

FIG. 2

FIG. 3

F I G. 4

F I G. 5

FORMATION OF
ACTIVE LAYER

FORMATION OF
OHMIC ELECTRODES

DEPOSITION OF
SCHOTTKY GATE

1 st. INTERCONNECT
METALIZATION

FORMATION OF
INSULATION FILM

2 nd. INTERCONNECT
METALIZATION

ADJUSTMENT OF
THRESHOLD VOLTAGE

# F I G. 6

# F I G. 7

F I G .  9

1C

1B

1A

1D

F I G .  10

2C

2D

Au
Ti
Mo

Pt-GaAs

2C

2B

2A